# EUROPÄISCHE PATENTSCHRIFT

(11) **EP 0 644 507 B1**
(45) Veröffentlichungstag und Bekanntmachung des Hinweises auf die Patenterteilung: **29.10.2003**
(21) Anmeldenummer: 94113533.7
(22) Anmeldetag: 30.08.1994
(51) Int. Cl.: G06K 19/077

(54) **Verfahren und Vorrichtung zum Herstellen eines Chipkarten-Moduls**
Manufacturing method and device for a chip-card module
Méthode et procédé de fabrication de modules pour carte à puce

(30) Priorität: 22.09.1993 DE 9314355 U
(43) Veröffentlichungstag der Anmeldung: 22.03.1995
(73) Patentinhaber: Gemplus GmbH, 70794 Filderstadt (DE)
(72) Erfinder: Schmidt, Frank-Thomas Dipl.-Chem., D-99891 Fischbach (DE); Koch, Volker Dipl.-Ing., D-99843 Thal (DE); Trittel, Jens Dipl.-Ing., D-99817 Eisenach (DE)
(74) Vertreter: Grünecker, Kinkeldey, Stockmair & Schwanhäusser Anwaltssozietät

(56) Entgegenhaltungen:
- EP-A- 0 132 183
- EP-A- 0 201 952
- EP-A- 0 211 360
- EP-A- 0 449 691
- EP-A- 0 469 970
- GB-A- 2 081 950
- US-A- 4 962 415

## Beschreibung

Die Erfindung betrifft ein Verfahren gemäß Oberbegriff Patentanspruch 1 und ein gerät gemäß Oberbegriff Patentanspruch 9.

Passive und aktive Chip-Karten mit wenigstens einem Speicher- und/oder Mikroprozessor-Chip werden in zunehmendem Maß verwendet, z.B. als Telefonkarten. Bei der Herstellung wird ein Chipkarten-Modul gefertigt, in eine Vertiefung eines Chipkartenrohlings eingesetzt und darin befestigt.

Nach einem aus DE-A1-30 29 667 bekannten Verfahren gemäß Oberbegriff des Patentanspruchs 1 wird bei der Herstellung des Chipkarten-Moduls der über die Leitungen mit Kontaktstellen des Trägers verbundene IC-Baustein in einem Formhohlraum mit eingespritzter Vergußmasse umhüllt. Der Formhohlraum bestimmt Form und Abmessungen der Vergußmasse am Chipkarten-Modul. Dies ist ein aufwendiges und teures Verfahren.

Gemäß EP-A-0 211 360 (Fig. 8 bis 12, Fig. 16) wird zur Herstellung des Moduls ein Glas-Epoxi-Film mit einem Elektrodenmuster versehen. Danach wird eine Schicht eines Schaltkreismusters mit einer Aussparung zum Einhängen des IC-Bausteins vorbereitet und am Träger befestigt. Eine Dichtrahmenschicht, deren Außenumriß größer ist als der Außenumriß des Trägers, wird an der Schicht des Schaltkreismusters befestigt. Die Dichtrahmenschicht besitzt einen Ausschnitt für den IC-Baustein, der eingesetzt und am Träger festgelegt wird. Nach dem Bondieren werden in einem Formhohlraum offene Räume um den IC-Baustein mit flüssigem Harz ausgefüllt. Gegebenenfalls wird die aufgrund der Harzfüllung unebene Rückseite des Moduls durch Polieren, Schleifen, Fräsen oder Abkratzen überschüssigen Harzes geglättet. Durch die Nachbearbeitung soll eine vorbestimmte Moduldicke erreicht werden. Dieses Herstellverfahren ist zeitaufwendig und kostenintensiv.

Bei einer aus US-A-49 62 415 (Fig. 2) bekannten Chipkarte werden der IC-Baustein in ein Fenster eines Film-Trägers eingesetzt und auf den Träger eine Verstärkungsplatte in Kappenform aufgesetzt, die einen Hohlraum für den IC-Baustein besitzt. Von der der Kappe gegenüberliegenden Seite wird auf den IC-Baustein eine Kuppe aus Vergußmaterial aufgebracht, die in die Kappe eindringt. Dann wird dieser Zwischenverbund in ein Fenster einer Mittelschicht der Chipkarte eingelegt, der Zwischenraum mit Harz ausgegossen und auf jeder Seite der Mittelschicht eine Abdeckschicht aufgebracht. Das Verfahren ist arbeitsintensiv und zeitaufwendig.

Gemäß EP A-0 469 970 wird der Modul in einer dreiteiligen Form so fertiggestellt, daß die Vergußmasse einen quaderförmigen Block auf dem Trägerplättchen bildet, wobei die Seitenflächen und die Oberfläche des Blocks durch die Formhohlraumwände geformt werden. Zum Fixieren des Moduls im Fenster des Kartenrohlings wird auf die ebene Oberseite des Blocks der ausgehärteten Vergußmasse eine als Kartenrohling abgestützte Metallplatte aufgeklebt. Das Verfahren ist apparativ aufwendig und erfordert eine Vielzahl von Verfahrensschritten.

Bei einem aus EP-A-0 132 183 bekannten Verfahren wird in eine einseitig offene Vertiefung des Kartenkörpers mittels eines Preßstempels eine Metallfolie eingepreßt, die eine Auskleidung für den nachfolgend eingesetzten und festgeklebten Modul bildet.

Um einen Datenverlust oder eine Zerstörung der Chipkarte durch äußere Einflüsse zu vermeiden, müssen Chipkarten strengen Prüfungen standhalten. Beispielsweise wird die mechanische Festigkeit durch Biegeversuche mit längsseitigen Auslenkungen, breitseitigen Auslenkungen und Verdrehungen auf Ausfälle geprüft. Typische Ausfälle sind ein Bruch des Trägers, ein Lösen des Chipkarten-Moduls aus der Verbindung in der Chipkarte oder ein Bruch des IC-Bausteins. Die mechanische Belastbarkeit wird deshalb u.a. durch den Verguß und die Qualität des Verbindungsbereichs zwischen dem Chipkarten-Modul und der Chipkarte bestimmt. Dabei ist es wichtig, daß der Chipkarten-Modul keinesfalls eine vorbestimmte Höchstdicke überschreitet, damit er in die Vertiefung der Chipkarte paßt und ordnungsgemäß festlegbar ist, ohne mit den Kontaktbereichen über die Oberfläche der Chipkarte vorzustehen oder dieser gegenüber zurückzutreten.

Der Erfindung liegt die Aufgabe zugrunde, ein Verfahren und ein gerät der eingangs genannten Art anzugeben, bei denen auf einfache Weise eine gewünschte und zuverlässig einhaltbare Dicke jedes Chipkarten-Moduls und eine verbesserte Abdeckung des IC-Bausteins und der Leitungen erreichbar sind.

Die gestellte Aufgabe wird erfindungsgemäß mit dem im Anspruch 1 angegebenen Verfahren und dem gerät gemäß Anspruch 9 gelöst.

Beim Verfahren gemäß Anspruch 1 wird kostengünstig eine bestimmte Dicke des Chipkarten-Moduls nachbearbeitungsfrei eingehalten, denn durch das Aufdrücken des steifen Deckplättchens mit seiner vorherbestimmten Form und Größe wird die Dicke des Chipkarten-Moduls exakt und reproduzierbar begrenzt. Das Deckplättchen deckt zusätzlich den IC-Baustein und die Leitungen ab und übernimmt eine Schutzfunktion für den IC-Baustein und die Leitungen. Es wird eine vorbestimmbare und gleichmäßige Vergußmassenverteilung erreicht, weil das Deckplättchen die Vergußmasse dorthin zwingt, wo sie gebraucht wird. Der Chipkarten-Modul ist für sich und in der Chipkarte den vorgeschriebenen Prüfungen und den Belastungen im praktischen Gebrauch gewachsen. Die Ausschußquote bei der Herstellung der Chipkarten-Module bzw. der Chipkarten bei Serienproduktion ist gering. Da die Höchstdicke der Chipkarten-Module dank des Deckplättchens nachbearbeitungsfrei einhaltbar ist, ergibt sich trotz rascher Herstellung eine hohe Qualität der Chipkarten und später des Verbindungsbereichs zwischen jedem Chipkarten-Modul und der Chipkarte.

Das gerät führt zu hohem Ausstoß qualitativ guter Module ohne jegliche Nachbearbeitung.

Das Verfahren gemäß Anspruch 2 ist mit korrekter Dosierung der Vergußmasse am Deckplättchen einfach durchführbar und insbesondere für die Massenproduktion zweckmäßig.

Bei der Ausführungsform gemäß Anspruch 3 wird die Vergußmasse unabhängig vom Aufbringen des Deckplättchens exakt dosiert. Dies kann verfahrenstechnisch von Vorteil sein.

Gemäß Anspruch 4 wird das Deckplättchen zum Verteilen und Ausbreiten der Vergußmasse eingesetzt. Eine vorbestimmte Verteilung ist erzielbar, ohne Verteilwerkzeuge mit Vergußmasse zu beschmutzen.

Gemäß Anspruch 5 wird die Dicke des Chipkarten-Moduls zuverlässig und einfach eingehalten. Die Lage des Deckplättchens ist auch bei Massenproduktion genau reproduzierbar.

Eine zweckmäßige Verfahrensform für die Massenproduktion geht aus Anspruch 6 hervor.

Die Verfahrensform gemäß Anspruch 7 ist im Hinblick auf einen raschen Verfahrensablauf zweckmäßig. Erwärmte Vergußmasse unterdrückt die Tendenz der Vergußmasse zum Fadenziehen.

Gemäß Anspruch 8 läßt sich eine minimale Moduldicke erreichen. Die zentrische Lage des Deckplättchens gewährleistet den Schutz des IC-Bausteins und der Leitungen bzw. der Bondinseln.

Anhand der Zeichnung werden Ausführungsformen der Erfindung erläutert. Es zeigen:
- Fig. 1: einen Längsschnitt einer ersten Ausführungsform eines Chipkarten-Moduls,
- Fig. 2: einen Längsschnitt einer zweiten Ausführungsform,
- Fig. 3: schematische Verfahrensschritte beim Herstellen eines Chipkarten-Moduls,
- Fig. 4: einen Schnitt einer Chipkarte,
- Fig. 5: schematisch eine Vorrichtung zum Durchführen des Verfahrens, und
- Fig. 6: eine alternative Ausführungsform einer solchen Vorrichtung.

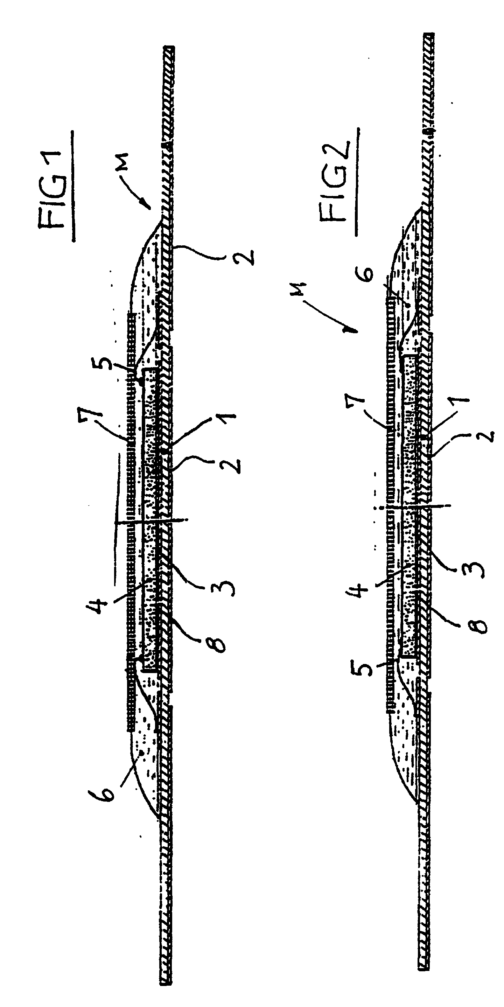

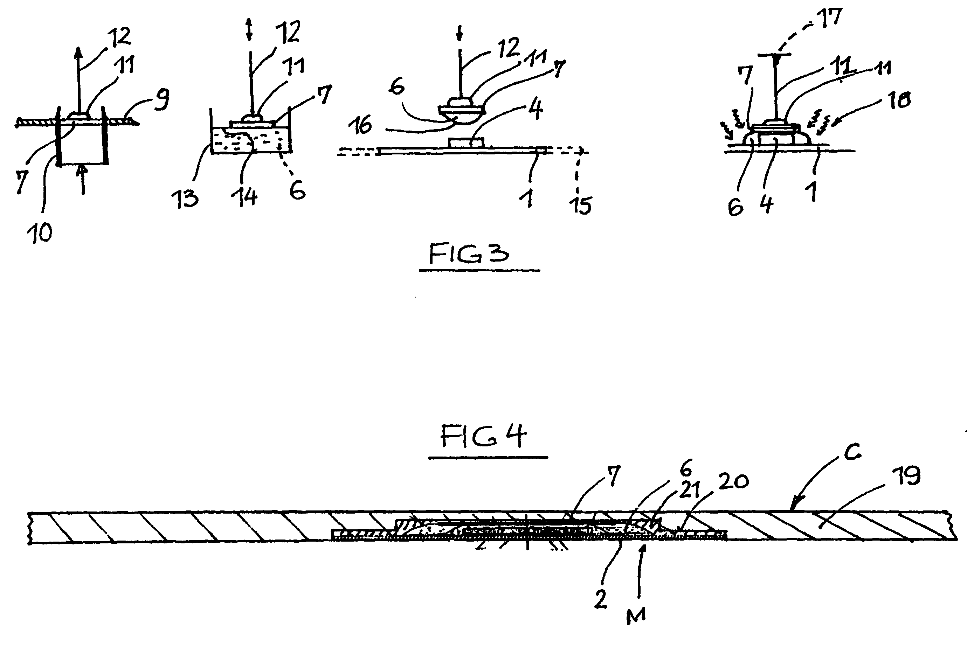

Ein Chipkarten-Modul M gemäß Fig. 1 besteht aus einem ebenen Abschnitt eines Trägers 1, der an seiner Unterseite Kontaktstellen 2 trägt, die durch isolierende Bereiche voneinander getrennt sind. Der Träger 1 ist zweckmäßigerweise ein Abschnitt eines Trägerstreifens 15 (s. Fig.3), in dem z.B. achtzehn Abschnitte miteinander verbunden sind. Es könnte aber auch ein endloser Streifen 15 benutzt werden. Auf der Oberseite (Bondseite) des Trägers 1 sind weitere Kontaktstellen 3 auf nicht dargestellte Weise mit den Kontaktstellen 2 kontaktiert und ein IC-Baustein 4 mittels einer Haftschicht 8 (Chipkleber) befestigt. Die Größe und Form des IC-Bausteins 4 richtet sich u.a. nach den Anforderungen, die er in einer Chipkarte C (Fig. 4) zu erfüllen hat. Leitungen 5 (in Fig. 1 z.B. Gold-Bonddrähte) verbinden den IC-Baustein 4 mit den Kontaktstellen 3. Auf die Oberseite des Trägers 1 ist ferner eine Vergußmasse 6 (z.B. ein Epoxi-Harz) aufgebracht, die sich über dem IC-Baustein 4 und über die Leitungen 5 hinweg nach außen bis über die die sogenannten Bondinseln und ggfs. über die Kontaktstellen 3 hinaus erstreckt. Die Vergußmasse 6 ist an der dem IC-Baustein 4 abgewandten Oberseite mit einem ebenen und gleichmäßig dicken Deckplättchen 7 abgedeckt, das mit seinem Umriß zumindest bis über die Bondinseln greift. Die freie Oberseite des Deckplättchens 7 ist eben und liegt im wesentlichen parallel zum Träger 1. Das Deckplättchen 7 besteht aus Kunststoff, Metall, einem Mineral- oder einem Verbundwerkstoff. Zweckmäßigerweise besteht das Deckplättchen 7 aus dem gleichen Werkstoff wie der Träger 1. Seine Dicke beträgt ca. 0,1mm. Die Dicke des Chipkarten-Moduls beträgt höchstens 0,62mm. Die freie Oberseite des Deckplättchens 7 liegt zumindest geringfügig höher als die Oberseite des Vergußmassenauftrags. Das Deckplättchen 7 kann (wie gezeigt) sogar auf den Leitungen 5 aufliegen und wird von der Vergußmasse 6 festgehalten.

Bei dem Chipkartenmodul gemäß Fig. 2 sind als Leitungen 5 Aluminium-Bonddrähte vorgesehen, deren Höhe oberhalb der Oberseite des IC-Bausteins 4 niedriger sind als in Fig. 1. Das Deckplättchen 7 ist in einem Abstand von den Leitungen 5 auf der Vergußmasse 6 angeordnet und wird von dieser festgehalten.

Die Verbindung des IC-Bausteins 4 mit den Kontaktstellen 3 bzw. 2 könnte auch auf andere, hier nicht gezeigte Weise durchgeführt werden. Das jeweils verwendete Deckplättchen 7 ist zweckmäßigerweise kreisrund (Durchmesser ca. 5.0mm). Es sind aber je nach Anwendungsfall auch polygonale Umrisse des Deckplättchens möglich. Ferner ist es denkbar, das Deckplättchen linsenförmig mit variierender Dicke oder gewölbt auzubilden. Wichtig ist, daß das Deckplättchen 7 mit seiner freien Oberseite eine in Bezug auf den Abstand zur Unterseite des Trägers 1 exakt reproduzierbare Begrenzung des Chipkarten-Moduls M definiert, so daß die Chipkarten-Module einer Bauserie gleich dick sind.

Anhand Fig. 3 wird ein Verfahren zum Herstellen der Chipkarten-Module M gemäß den Fig. 1 und 2 erläutert. Zunächst wird mit einem Stanzwerkzeug 10 aus einem Folienband 9 ein Deckplättchen 7 ausgestanzt. Ein Positionierelement 12 mit einem Unterdrucksauger 11, ergreift das Deckplättchen 7 und führt es in einen Behälter 13, in dem Vergußmasse 6 auf genau eingestelltem Niveau 14 bereitgehalten ist. An der Unterseite des Deckplättchens 7, die glatt oder geglättet ist, haftet ein Tropfen 16 der Vergußmasse 6. Das Deckplättchen 7 wird vom Positionierelement 12 aufgesetzt und gegebenenfalls geringfügig aufgedrückt, um die gewünschte Höhe des Chipkarten-Moduls zu erreichen. Dabei wird entweder das Deckplättchen 7 über den IC-Baustein 4 bewegt oder der IC-Baustein 4 mit dem Träger 1 (in Streifen 15, strichliert angedeutet) unter das Deckplättchen 7 bewegt. Das Deckplättchen 7 wird zentrisch zum IC-Baustein 4 aufgedrückt, damit die Vergußmasse 6 seitlich ausgebreitet wird und die in Fig. 3 nicht gezeigten Leitungen umschließt. Dann wird, wie bei 18 angedeutet, mit Wärme oder energiereichen Strahlen die Vergußmasse 6 gehärtet. Dabei kann das Deckplättchen 7 weiterhin unter Druck (Pfeil 17) gehalten, oder zuvor durch Belüften des Saugers 11 freigegeben werden.

Der fertige Chipkarten-Modul M wird später aus dem Verbund des Bandes 15 herausgelöst und in einen Chipkartenrohling einer Chipkarte C eingebracht.

Gemäß Fig. 4 ist in der Chipkarte C, die z.B. einen Laminataufbau 19 mit nicht gezeigten Identifikations-, Dekorations- oder Schutzmaßnahmen aufweist, an einer Seite eine vorgefertigte Vertiefung 20 geformt, die in etwa auf die Form und Dicke des Chipkarten-Moduls M abgestimmt ist. Der Chipkarten-Modul M wird in die Vertiefung 20 eingelegt und mit einem Haftmittel 21 so festgelegt, daß die Kontaktstellen 2 genau mit der Unterseite der Chipkarte C fluchten. Das Deckplättchen 7 kommt gegebenenfalls am Grund der Vertiefung 21 zur Anlage oder liegt dem Grund mit einem Zwischenabstand gegenüber, der durch das Haftmittel 21 ausgefüllt ist.

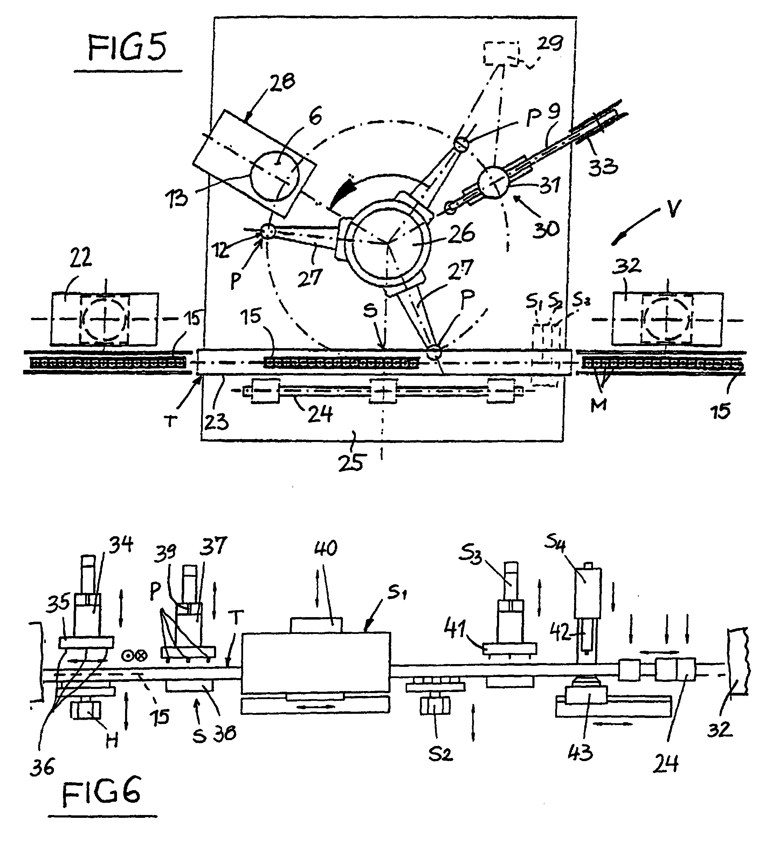

Fig. 5 ist eine schematische Draufsicht auf eine Vorrichtung V zum Passivieren von Chipkarten-Modulen M, die jeweils in einem Streifen 15 aus einem Speicher 22 bereitgestellt werden. Der Streifen 15 wird in eine geradlinige Transportstrecke T eingeführt und in einer Führungsbahn 23 mittels eines Taktvorschubs 24 intermittierend durch eine Arbeitsstation S bewegt, ehe er nachfolgend weitere, nur strichliert angedeutete Stationen, S1, S2, S3 passiert und in einem Sammler- oder Speicher 32 anlangt. Die Transportstrecke T ist auf einer Platte 25 angeordnet, die einen um eine vertikale Achse drehbaren Ständer 26 trägt. Am Ständer 26 sind, z.B. drei um jeweils 120° zueinander versetzte Arme 27 angebracht, an deren freien Enden Positionierelemente P, 12 vorgesehen sind. In der Kreisbahn der Positionierelemente P, 12 und in etwa auf der Höhenlage der Arbeitsstation S der Transportstrecke T ist eine Deckplättchen-Bereitstellungs-Station 30 und eine Vergußmassen-Station 28 vorgesehen. Jedes Positionierelement P, 12 ist durch eine nicht gezeigte Antriebsvorrichtung hebbar und senkbar, wobei die Hebe- und Senkbewegungen der Positionierelemente benutzt werden, um jeweils mindestens ein Deckplättchen aufzunehmen, mit Vergußmasse 6 zu benetzen, und auf die vorbestimmte Höhenlage in der Arbeitsstation S auf einen Modul M aufzudrücken.

In der Vergußmassen-Station 28 ist der zweckmäßigerweise drehbare Rakeltopf 13 vorgesehen, in den die Vergußmasse 6 mittels eines nicht gezeigten Rakelelements stets auf der gleichen Höhe bereitgehalten wird. Die Drehbewegung des Rakeltopfs 13 ist bei Benetzen eines Deckplättchens unterbrechbar. In der Deckplättchen-Bereitstellungsstation 30 ist eine Stanzvorrichtung 31 vorgesehen, die aus einem Magazin 33 mit der streifenförmigen Folie 9 beschickt wird, aus der das in Fig. 5 nicht gezeigte Stanzwerkzeug Deckplättchen 7 ausstanzt und an das Positionierelement P, 12 übergibt. Beim Stanzen hält das Stanzelement (s. Fig. 3) das Deckplättchen solange mittels Unterdruckbeaufschlagung fest, bis es an das Positionierelement P, 12 übergeben ist, das ebenfalls mit Unterdruckbeaufschlagung (Druckquelle 29) arbeitet. Erst dann wird die Unterdruckbeaufschlagung des Stanzwerkzeuges abgebaut, um eine seitliche Verschiebung oder ein Kippen des Deckplättchens zu vermeiden. Nach dem Aufdrücken des Deckplättchens in der Arbeitsstation S kann sogar mit einem Druckimpuls ein zuverlässiges Lösen des Deckplättchens vom Positionierelement P, 12 eingesteuert werden.

Die tiefste Absenklage des Positionierelements P, 12 in der Arbeitsstation S wird durch eine nicht gezeigte Feinmeßspindel exakt eingestellt.

Bei einer alternativen Ausführungsform der Vorrichtung V gemäß Fig. 6 sind in Transportrichtung der Streifen 15 entlang der Transportstrecke T folgende Stationen vorgesehen. Eine Vergußmassen-Dosier- und Auftragestation 34, die Arbeitsstation S für das Positionierelement P, eine Aushärtestation S1, eine Prüfstation S2, eine Dikkenmeßstation S3 und eine Ausschuß-Aussonderungsstation S4. Der Taktvorschub ist mit 24 angedeutet.

In der Station 34 ist ein in mehreren Richtungen antreibbarer Kreuztisch 35 vorgesehen, an dem z.B. ein Mehrfachdosierkopf 36 für die Vergußmasse angeordnet ist. An der Unterseite der Transportstrecke kann dort eine Heizvorrichtung H für den Streifen 15 angeordnet sein. Der Kreuztisch 35 läßt sich in Fig. 6 in der Zeichenebene vertikal bezüglich der Transportstrecke T bewegen. Der Mehrfach-Dosierkopf 36 wird dabei aus einer nicht dargestellten Dosiervorrichtung mit der Vergußmasse beschickt. Denkbar ist ferner, daß der Kreuztisch 35 zusätzlich senkrecht zur Zeichenebene zu bewegen und Auftragelemente für Vergußmasse 6 in einen Rakeltopf 13 wie in Fig. 5 einzutauchen sind, ehe die Module mit der Vergußmasse versehen werden. Die Heizvorrichtung H läßt sich ebenfalls vertikal zur Transportstrecke T verstellen, um die Heizintensität beeinflussen zu können.

In der Arbeitsstation S sind die Positionierelemente P an einer Konsole 37 angebracht, die sich mittels eines nicht dargestellten Bewegungsantriebes in der Zeichenebene vertikal zur Transportstrecke T und auch senkrecht zur Zeichenebene verstellen läßt, wie auch der Kreuztisch 35. Hinter der Zeichenebene (oder davor) ist eine Stanzvorrichtung (nicht gezeigt) zum Herstellen jeweils dreier Deckplättchen vorgesehen, die bei jedem Takt an die Positionierelemente P übergeben und von den Positionierelementen P mittels Unterdruckbeaufschlagung und eines abschließenden lösenden Druckimpulses auf die Module aufgedrückt werden. Eine Feinmeßspindel 39 dient zum exakten Einstellen der tiefsten Absenkposition der Positionierelemente P. Unter der Arbeitsstation S ist ein Gegenhalter 38 vorgesehen, der zusätzlich dazu benutzt werden kann, jeweils drei Module exakt zu positionieren, die mittels des Taktvorschubes 24 zur Arbeitsstation S gebracht wurden. In der Aushärtestation S1 ist beispielsweise ein Tunnelofen 20 vorgesehen, oder eine Quelle energiereicher Strahlen zum Aushärten der Vergußmasse. In der Prüfstation S2 werden die Module nacheinander auf ihre elektronische Funktion überprüft, ehe in der Dickenmeßstation S3 mittels eines Meßkopfes 41 die Dicke jedes Moduls geprüft wird. Werden in den Stationen S2 und S3 außerhalb eines Toleranzbereiches liegende Module festgestellt, dann wird die Station S4 aktiviert, in der mittels einer Stanze 42 jedes Ausschußmodul ausgesondert und durch einen Teil 43 entfernt wird. Im Magazin 32 wird der Streifen aus fertigen und geprüften Modulen zur weiteren Verarbeitung gesammelt.

In der Vorrichtung gemäß Fig. 5 könnten mit jedem Positionierelement P auch gleichzeitig zwei Deckplättchen verarbeitet werden. In der Vorrichtung V gemäß Fig. 6 kann bei jedem Takt eine beliebige Anzahl von Deckplättchen verarbeitet werden, z.B. abhängig von der Anzahl der Träger 1 im Streifen 15.

Bei beiden Ausführungsformen der Vorrichtung V läßt sich mit einer Taktzeit zwischen zwei und fünf Sekunden, vorzugsweise zwischen 2,5 und 3,5 Sekunden eine Ausstoßrate von in etwa 875 passivierten Modulen pro Stunde erreichen. Die Vorrichtung V ist von einer computerisierten, vollautomatischen Steuerung gesteuert und überwacht. Der Rakeltopf kann mit einer Drehzahl zwischen 2 und 40 min⁻¹ gedreht werden. Der Rakeltopf ist zur Reinigung leicht demontierbar.

## Patentansprüche

1. Verfahren zum Herstellen eines Chipkarten-Moduls (M), bei dem mindestens auf die Leitungen (5), die wenigstens einen an einem Träger (1) angebrachten IC-Baustein (4) mit am Träger vorgesehenen Kontaktstellen verbinden, eine aushärtbare Vergussmasse (6) aufgebracht wird, **dadurch gekennzeichnet, dass** die Vergussmasse (6) vor dem Aushärten auf der dem Träger (1) abgewandten Seite des IC-Bausteins (4) mittels eines auf die Vergussmasse aufgedrückten Deckplättchens (7) in der Dicke festgelegt wird.

2. Verfahren nach Anspruch 1, **dadurch gekennzeichnet, dass** die Vergussmasse (6) auf die Unterseite des Deckplättchens (7) aufgebracht und die Vergussmasse (6) mit dem Deckplättchen (7) nachbearbeitungsfrei auf den Träger (1) und den IC-Baustein (4) aufgedrückt wird.

3. Verfahren nach Anspruch 1, **dadurch gekennzeichnet, dass** die Vergussmasse (6) auf den IC-Baustein (4) und den Träger (1) aufgebracht und das Deckplättchen (7) nachbearbeitungsfrei auf die Vergussmasse (6) aufgedrückt wird.

4. Verfahren nach wenigstens einem der Ansprüche 1 bis 3, **dadurch gekennzeichnet, dass** die Vergussmasse (6) durch Druckbeaufschlagung des Deckplättchens (7) bis über dessen Umfang ausgebreitet wird.

5. Verfahren nach wenigstens einem der Ansprüche 1 bis 4, **dadurch gekennzeichnet, dass** das Deckplättchen (7) nur so weit in die Vergussmasse (6) eingedrückt wird, dass die freie Oberseite des Deckplättchens oberhalb der über den Umfang des Deckplättchens (7) ausgebreiteten Vergussmasse (6) liegt.

6. Verfahren nach wenigstens einem der Ansprüche 1 bis 5, **gekennzeichnet durch** folgende Schritte:
Das Deckplättchen (7) wird ausgestanzt und ergriffen,
das ergriffene Deckplättchen (7) wird einseitig mit Vergussmasse (6) benetzt,
das ergriffene und benetzte Deckplättchen (7) wird auf den mit dem IC-Baustein (4) bestückten, kontaktierten Träger (1) aufgedrückt, und
die Vergussmasse (6) wird ausgehärtet, wobei das Deckplättchen (7) entweder vor oder nach dem Aushärten freigegeben wird.

7. Verfahren nach wenigstens einem der Ansprüche 1 bis 6, **dadurch gekennzeichnet, dass** die Vergussmasse (6) erwärmt wird, vorzugsweise bis auf höchstens 60°C.

8. Verfahren nach wenigstens einem der Ansprüche 1 bis 7, **dadurch gekennzeichnet, dass** das Deckplättchen (7) unter Umhüllen von Bonddrähten, die den IC-Baustein (4) mit den Kontaktstellen (3, 2) verbindende Leitungen (5) bilden, und Umschließen der Bondinseln mit der Vergussmasse (6) auf den IC-Baustein (4) zentriert und höchstens bis zur Auflage auf den Bonddrähten aufgedrückt wird.

9. Gerät zum Herstellen von Chipkarten-Modulen (M) mit aushärtbarer Vergussmasse (6), mit einer Vergussmassen-Station zum Aufbringen der Vergussmasse auf einen ebenen Träger (1) jedes Chipkarten-Moduls (M), **dadurch gekennzeichnet, dass** eine Trägertransportstrecke (D) mit wenigstens einer Arbeitsstation (S) für wenigstens einen zum Passivieren lagegesicherten Träger (1) vorgesehen ist, dass ein drehbarer Ständer (26) am synchronen Bewegen mehrerer Deckplättchen-Positionierelemente (P, 12) entlang einer die Arbeitsstation (S) überschneidenden Kreisbahn vorgesehen ist, dass in der Kreisbahn eine Deckplättchen-Bereitstellungsstation (30) und eine Vergussmassen-Station (28) vorgesehen sind, und dass eine Antriebsvorrichtung zum Auf- und Abverstellen der Deckplättchen-Positionierelemente (P, 12) an dem Ständer (26) relativ zu einer definierten Lage vorgesehen ist, wobei die Vergussmasse (6) vor dem Aushärten auf der dem Träger (1) abgewandten Seite des IC-Bausteins (4) mittels des auf die Vergussmasse (6) aufgedrückten Deckplättchens (7) in der Dicke festgelegt wird.

10. Gerät nach Anspruch 9, **dadurch gekennzeichnet, dass** in der Deckplättchen-Bereitstellungsstation (30) eine Deckplättchen-Stanzvorrichtung (31) vorgesehen ist.

11. Gerät nach Anspruch 9, **dadurch gekennzeichnet, dass** zum Einstellen der definierten abgesenkten Lage jedes Deckplättchen-Positionierelements (P, 12) ein Feinmessspindel (39) vorgesehen ist.

## Claims

1. Method of manufacturing a chip-card module (M), wherein a curable encapsulating material (6) is applied to at least the lines (5) connecting at least one IC module (4) attached to a substrate (1) to contact pads provided on the substrate, **characterized in that** the thickness of the encapsulating material (6) is established prior to curing on that side of the IC module (4) that faces away from the substrate (1) by means of a cover platelet (7) which is pressed onto the encapsulating material.

2. Method as claimed in Claim 1, **characterized in that** the encapsulating material (6) is applied to the bottom surface of the cover platelet (7) and the encapsulating material (6) including the cover platelet (7) is pressed onto the substrate (1) and the IC module (4) without any need for postprocessing.

3. Method as claimed in Claim 1, **characterized in that** the encapsulating material (6) is applied to the IC module (4) and the substrate (1) and the cover platelet (7) is pressed onto the substrate (1) and the IC module (4) without any need for postprocessing.

4. Method as claimed in at least one of Claims 1 to 3, **characterized in that** the encapsulating material (6) is spread up to over the peripery of the cover platelet (7) by applying pressure onto the latter.

5. Method as claimed in at least one of Claims 1 to 4, **characterized in that** the cover platelet (7) is pressed into the encapsulating material (6) only to such an extent that the free upper surface of the cover platelet lies above the encapsulating material (6) spread over the periphery of the cover platelet (7).

6. Method as claimed in at least one of Claims 1 to 5, **characterized by** the following steps:
the cover platelet (7) is punched out and grasped,
the grasped cover platelet (7) is wetted with encapsulating material (6) on one surface thereof;
the grasped and wetted cover platelet (7) is pressed onto the bonded substrate (1) equipped with the IC module (4); and
the encapsulating material (6) is cured, the cover platelet (7) being released either before or after curing.

7. Method as claimed in at least one of Claims 1 to 6, **characterized in that** the encapsulating material (6) is heated to a temperature of preferably no more than 60°C.

8. Method as claimed in at least one of Claims 1 to 7, **characterized in that** the cover platelet (7) is pressed on in such a way that bond wires forming the lines (5) connecting the IC module (4) to the contact pads (3, 2) are enveloped and the bond pads are enclosed, with the encapsulating material (6) centred on the IC module (4), and no deeper than until they rest on the bond wires.

9. Device for manufacturing chip-card modules (M) with a curable encapsulating material (6), comprising an encapsulation station for applying the encapsulating material onto a level substrate (1) of each chip-card module (M), **characterized in that** a substrate transfer distance (D) including at least one work station (S) is provided for at least one substrate (1) fixed in its location for passivation, **in that** a rotatable stand (26) for synchronously moving several cover platelet locating elements (P, 12) along a circular trajectory intersecting the work station (S) is provided, **in that** a cover platelet supply station (30) and an encapsulation station (28) are provided on the circular trajectory, and **in that** driving means for height adjusting the cover platelet positioning elements (P, 12) on the stand (26) relative to a predefined location are provided, with the thickness of the encapsulating material (6) being established prior to curing on that side of the IC module (4) which faces away from the substrate (1) by means of the cover platelet (7) pressed onto the encapsulating material (6).

10. Device as claimed in Claim 9, **characterized in that** a cover platelet punching device (31) is provided in the cover platelet supply station (30).

11. Device as claimed in Claim 9, **characterized in that** a precision measuring spindle (39) is provided for adjusting the predefined lowered location of each cover platelet locating element (P, 12).

## Revendications

1. Procédé de fabrication d'un module de carte à puce (M), dans lequel est appliquée une masse de remplissage (6) durcissable au moins sur les circuits (5), qui relient au minimum un élément de circuit intégré (4) monté sur un support (1) à des points de contact prévus au niveau du support, **caractérisé en ce que** la masse de remplissage (6) est définie dans l'épaisseur avant le durcissement sur la face de l'élément de circuit imprimé (4) opposée au support (1) au moyen d'une plaquette de recouvrement (7) apposée sur la masse de remplissage.

2. Procédé selon la revendication 1, **caractérisé en ce que** la masse de remplissage (6) est appliquée sur la face inférieure de la plaquette de recouvrement (7) et la masse de remplissage (6) est apposée avec la plaquette de recouvrement (7) sur le support (1) et l'élément de circuit imprimé (4) sans traitement ultérieur.

3. Procédé selon la revendication 1, **caractérisé en ce que** la masse de remplissage (6) est appliquée sur l'élément de circuit imprimé (4) et le support (1) et la plaquette de recouvrement (7) est apposée sur la masse de remplissage (6) sans traitement ultérieur.

4. Procédé selon l'une au moins des revendications 1 à 3, **caractérisé en ce que** la masse de remplissage (6) est répartie par pressurisation de la plaquette de recouvrement (7) jusqu'au-delà de la circonférence de celle-ci.

5. Procédé selon l'une au moins des revendications 1 à 4, **caractérisé en ce que** la plaquette de recouvrement (6) est entrée par pression dans la masse de remplissage (6) seulement jusqu'à ce que la face supérieure libre de la plaquette de recouvrement se situe au-dessus de la masse de remplissage (6) répartie au-delà de la circonférence de la plaquette de recouvrement (7).

6. Procédé selon l'une au moins des revendications 1 à 5, **caractérisé par** les étapes suivantes :
la plaquette de recouvrement (7) est découpée et saisie,
la plaquette de recouvrement (7) saisie est enduite d'un côté avec de la masse de remplissage (6),
la plaquette de recouvrement (7) saisie et enduite est apposée sur le support (1) équipé et mis en contact avec l'élément de circuit imprimé (4), et
la masse de remplissage (6) est durcie, la plaquette de recouvrement (7) étant relâchée soit avant, soit après le durcissement.

7. Procédé selon l'une au moins des revendications 1 à 6, **caractérisé en ce que** la masse de remplissage (6) est réchauffée, de préférence jusqu'à 60°C au maximum.

8. Procédé selon l'une au moins des revendications 1 à 7, **caractérisé en ce que** la plaquette de recouvrement (7) se met au centre de l'élément de circuit imprimé (4), en enveloppant les fils de bonding qui forment les circuits (5) reliant l'élément de circuit imprimé (4) aux points de contact (3, 2), et en entourant les îlots de bonding avec la masse de remplissage (6), et est appuyée au maximum jusqu'à l'application sur les fils de bonding.

9. Dispositif de fabrication de modules de cartes à puce (M) avec une masse de remplissage (6) durcissable, avec un poste de masse de remplissage pour l'application de la masse de remplissage sur un support (1) lisse de chaque module de carte à puce (M), **caractérisé en ce qu'**il est prévu une trajectoire de transport du support (D) avec au moins un poste de travail (S) pour au moins un support (1) à emplacement fiable pour la passivation, qu'il est prévu un support (26) rotatif au niveau du mouvement synchrone de plusieurs éléments de positionnement des plaquettes de recouvrement (P, 12) le long d'une trajectoire circulaire chevauchant le poste de travail (S), qu'il est prévu un poste de préparation des plaquettes de recouvrement (30) ainsi qu'un poste de masse de remplissage (28) dans la trajectoire circulaire, et qu'il est prévu un dispositif de commande pour déplacer vers le haut et le bas les éléments de positionnement des plaquettes de recouvrement (P, 12) au niveau du support (26) relativement à une position définie, la masse de remplissage (6) étant fixée dans l'épaisseur avant le durcissement sur la face, opposée au support (1), de l'élément de circuit imprimé (4) au moyen de la plaquette de recouvrement (7) appuyée sur la masse de remplissage (6).

10. Dispositif selon la revendication 9, **caractérisé en ce qu'**un dispositif de découpage des plaquettes de recouvrement (31) est prévu dans le poste de préparation des plaquettes de recouvrement (30).

11. Dispositif selon la revendication 9, **caractérisé en ce qu'**il est prévu une broche de mesure de précision (39) pour régler la position abaissée définie de chaque élément de positionnement des plaquettes de recouvrement (P, 12).
